# EUROPEAN PATENT APPLICATION

(11) **EP 4 550 397 A1**
(43) Date of publication of application: **07.05.2025**
(21) Application number: 23207608.3
(22) Date of filing: 03.11.2023
(51) Int. Cl.: H01L 21/822, H01L 21/8238, H01L 29/06

(54) **METHOD FOR PROCESSING A CFET DEVICE**

(71) Applicant: Imec VZW, 3001 Leuven (BE)
(72) Inventor: Peter, Antony Premkumar, 3001 Heverlee (BE); Petersen Barbosa Lima, Lucas, 3001 Heverlee (BE); Demuynck, Steven, 3200 Aarschot (BE); Sepulveda Marquez, Alfonso, 3000 Leuven (BE)
(74) Representative: Roth, Sebastian

(57) **Abstract**

The disclosure relates to a method for processing a CFET device (10). The method comprises the steps of: forming at least one fin structure (23) extending horizontally in one direction on a substrate (14), wherein the at least one fin structure (23) comprises a first layer stack (23a) and a second layer stack (23b) above the first layer stack, wherein the first layer stack (23a) comprises at least a first channel layer (11a) and the second layer stack (23b) comprises at least a second channel layer (12a); forming a set of gate structures (32) around the at least one fin structure (23), wherein the set of gate structures (32) are arranged perpendicular to the at least one fin structure (23) and at a determined distance to each other, and wherein the set of gate structures (32) covers the at least one fin structure (23) in channel regions (51) and exposes the at least one fin structure (23) in fin cut regions (52) on opposite sides of the channel regions (51); forming preliminary fin cuts by at least partially removing the at least one fin structure (23) in the fin cut regions (52), thereby generating a respective recess (53) between the gate structures (32), wherein end surfaces of the channel layers (11a, 12a) of the first and the second layer stack (23a, 23b) are exposed in the recess (53); and forming a cover layer (54) which partially covers the side walls of the recess (53), wherein the cover layer (54) thereby covers the exposed end surfaces of the second channel layer(s) (12a) but does not cover the exposed end surfaces of the first channel layer(s) (11a).

## Description

### TECHNICAL FIELD

The present disclosure refers to a method for processing a complementary field effect transistor (CFET) device.

### BACKGROUND

In a CFET, different transistor structures, particularly NMOS and PMOS transistors, may be stacked on top of each other. Compared, for example, to a nanosheet device, which comprises NMOS and PMOS transistors arranged side by side with a spacing in between them. The stacking of the transistor structures enables increasing an effective channel width.

A crucial step in the CFET fabrication is the engineering of the source and drain (S/D) terminals of the stacked (top and bottom) transistor structures. Typically, the S/D terminals are subsequently formed on the channels of the bottom and top transistor structure in a complex process which requires multiple CFET-specific process modules, including the formation and removal of multiple layers, until the bottom and top epi are engineered.

It would be advantageous to reduce the number of steps (deposition, etching and/or cleaning) and modules during S/D engineering in order to reduce the complexity of the CFET fabrication.

### SUMMARY

Thus, it is an objective to provide an improved method for processing a CFET device. In particular, the above-mentioned disadvantages should be avoided.

The objective is achieved by the embodiments provided in the enclosed independent claims. Advantageous implementations of the embodiments of the invention are further defined in the dependent claims.

A first aspect of this disclosure provides a method for processing a complementary field effect transistor (CFET) device. The method comprises the steps of: forming at least one fin structure extending horizontally in one direction on a substrate, wherein the at least one fin structure comprises a first layer stack and a second layer stack above the first layer stack, wherein the first layer stack comprises at least a first channel layer and the second layer stack comprises at least a second channel layer; forming a set of gate structures around the at least one fin structure, wherein the set of gate structures are arranged perpendicular to the at least one fin structure and at a determined distance to each other, and wherein the set of gate structures covers the at least one fin structure in channel regions and exposes the at least one fin structure in fin cut regions on opposite sides of the channel regions; forming preliminary fin cuts by at least partially removing the at least one fin structure in the fin cut regions, thereby generating a respective recess between the gate structures, wherein end surfaces of the channel layers of the first and the second layer stack are exposed in the recess; and forming a cover layer which partially covers the side walls of the recess, wherein the cover layer thereby covers the exposed end surfaces of the second channel layer(s) but does not cover the exposed end surfaces of the first channel layer(s).

This achieves the advantage that a cover layer can be generated in the recess between two gate structures, which exposes the channel layers of a bottom transistor but covers the channel layers of a top transistor of the CFET device. This greatly facilitates the engineering of a bottom source or drain (S/D) epi and prevents undesired epi growth (at the top) during bottom S/D formation.

Moreover, the formation of the non-conformal cover layer in the recess can eliminate the need for an additional cover spacer (CSP) module, which protects the top channel during bottom S/D epi growth. Thus, several constraints associated with the CSP module set-up can be avoided. For instance, a spin-on-carbon deposition is typically required to protect the bottom channels prior to CSP module deposition, which causes additional efforts when using a CSP module.

The first channel layer(s) can be the channel(s) of a first transistor structure and the second channel layer(s) can be the channel(s) of a second transistor structure of the CFET device.

The first (or bottom) transistor structure can be arranged in a first tier (or level) and the second (or top) transistor structure can be arranged in a second tier (or level) of the CFET device, wherein the second tier is arranged above the first tier. This may result in stacked transistor structures of the CFET device. The CFET device may comprise further transistor structures or other elements, which could respectively be directly above or beneath the first and second transistor structure.

For instance, the CFET device comprises the first transistor structure and the second transistor structure. A CFET cell can comprise one or more CFET devices or parts thereof. The CFET device may be a unit of the CFET cell.

Notably, in this disclosure the terms "below" and "above", "bottom" and "top", or similar terms are to be interpreted relative to each other. In particular, these terms describe opposite sides of the CFET device, or opposite side of any element of the CFET device. The terms may describe a relationship of elements (e.g., transistor structures, signal routing lines, power rails, etc.) of the CFET device along the direction of stacking of the tiers (or levels) of the CFET device. The stacking direction may thus align with the arrangement of the two tiers (or even more than two tiers) of the CFET device. That is, the two or more tiers (or levels), which are arranged above each other, are arranged one after the other along a certain direction (the stacking direction).

A transistor structure in this disclosure may be or may comprise a transistor, for example a field effect transistor (FET), or may be or may comprise a more complex semiconductor-based structure, which functions like a transistor. For instance, the semiconductor-based structure may be a nanosheet structure, a fin structure, or a forksheet structure, for example, provided with a gate partly wrapping around or fully wrapping around channel portions. The latter may be for instance a gate-all-around structure.

The transistor structures of the CFET device of the first aspect may be NMOS and PMOS transistor structures. For instance, the first transistor structure may be an NMOS transistor structure and the second transistor structure a PMOS transistor structure, or vice versa

The gate structures can be dummy gate structures respectively dummy gate electrode structures. The dummy gate structures can be replaced by metal gates (i.e., electrodes) in later steps.

The cover layer can be an inner spacer layer or inner spacer module. The cover layer can cover the side walls of the gate structures above the recess.

For instance, forming fin cuts means forming cuts, interruptions or gaps extending across the fin structure such that a fin portion is formed on either side of the cut. The preliminary fin cuts may extend through the fin structure to a preliminary cut level (above an intended final cut level).

Hereby, processing the CFET device may refer to fabricating or manufacturing the CFET device.

In an embodiment, the cover layer is made of a dielectric material, such as SiN, SiOC, SiON or SiCN.

In an embodiment, the cover layer is formed by a plasma enhanced atomic layer deposition (PEALD) process.

In an embodiment, forming the cover layer comprises: depositing the cover layer in the recess with a non-uniform layer thickness.

For instance, the cover layer can be directly deposited as a non-conformal layer (i.e., non-uniform layer) in the recess.

In an embodiment, the layer thickness of the cover layer gradually decreases from a top region of the recess, which faces away from the substrate, towards a bottom region of the recess, which faces towards the substrate.

In an embodiment, the cover layer is deposited in the top region of the recess with a higher deposition rate than in the bottom region of the recess.

This can be due to the high aspect ratio of the gate structures on both sides of the recess which allows less film forming precursors or atoms to reach the bottom of the recess during deposition. This effect can be enhanced if the distance between two gate structures is low and/or if the side surfaces of the gate structures are covered by additional layers further limiting the space between two gate structures.

In an embodiment, forming the cover layer further comprises: removing a portion of the cover layer which was deposited in the bottom region of the recess by an etching step.

In this way, the cover layer can be removed in a bottom region of the recess, where the exposed end surface of the (bottom) channel layer(s) are arranged. As a consequence, the end surfaces of the bottom channel layers are no longer covered by the cover layer.

This can be facilitated by the fact that the cover layer has a lower layer thickness in the bottom region of the recess, allowing it to be fully removed there, while the cover layer stays intact in a top region of the recess where it has a larger layer thickness.

The etching can be a wet etching, e.g. with a hydrofluoric acid (HF) solution.

In another example, the cover layer material is not deposited in the bottom region of the recess during a deposition step, or only a small amount of the cover layer material is deposited in the bottom region (e.g., due to the high aspect ratio of the recess). In this case, it might not be necessary to carry out a removal step (e.g., an extra etching step) for removing the cover layer in the bottom region in order to grow the source and/or drain (S/D) epi in this region.

In an embodiment, the method further comprises the step of: forming an oxide layer in the recess prior to forming the cover layer, wherein the cover layer is formed on the oxide layer. For example, the oxide layer is deposited via ALD (atomic layer deposition).

This can lead to a further reduction of the uniformity of the cover layer and, in particular, to a thickness variation of the cover layer on the high aspect ratio gate structures. For instance, when a PEALD SiN cover layer is applied on an oxide liner (ox+SiN), the SiN thickness depends on the incubation of SiN on the oxide underlayer. Due to plasma from the SiN deposition being unable to recover incubation from side-wall top to bottom (i.e., the time during which SiN is not sufficiently deposited may vary from top to bottom), a varied SiN growth and nonuniformity across the side-walls of the recess respectively the gate structures can occur.

In an embodiment, the method further comprises the step of: forming a source and/or drain structure in the recess, wherein the source and/or drain structure is arranged to electrically contact the exposed end surfaces of the first channel layer(s).

The source and/or drain structure can be a bottom source and/or drain structure, i.e. a source and/or drain structure of a bottom transistor structure of the CFET device.

In an embodiment, the source and/or drain structure is only formed on surface regions of the recess which are not covered by the cover layer.

Thus, the source and/or drain structure is formed to electrically contact the exposed layers of the layer stack which are not covered by the cover layer.

In an embodiment, the source and/or drain structure is formed by an epitaxial growth process. Thus, the source and/or drain structures can be source and/or drain epitaxial structures.

In particular, the source and/or drain (S/D) epi does not grow on the cover layer. Therefore, no undesired SD epitaxial growth occurs in regions of the recess that are covered by the cover layer.

In an embodiment, the method further comprises the step of: forming a further source and/or drain structure in the recess, wherein the further source and/or drain structure is arranged to electrically contact the second channel layer.

The further source and/or drain structure can be a top source and/or drain structure, i.e. a source and/or drain structure of a top transistor structure of the CFET device.

The (bottom) source and/or drain structure can be an n-type structure and the further (top) source and/or drain structure can be a p-type structure or vice versa.

In an embodiment, the cover layer covering the end surfaces of the second channel layer is removed prior to the formation of the further source and/or drain structure.

For instance, after metallization of the (bottom) source and/or drain structure, a metal recess can be carried out and the cover layer covering the second channel layer can be removed. This can be followed by a deposition of an Si₃N₄ liner and/or an SiO layer in the recess. Subsequently, the Si₃N₄/SiO₂ layer(s) can be partially removed and a metallization of the further S/D structure can be carried out.

A second aspect of this disclosure provides a complementary field effect transistor (CFET) device obtainable by the method according to the first aspect of the disclosure.

### BRIEF DESCRIPTION OF THE DRAWINGS

The above described aspects and implementations are explained in the following description of embodiments with respect to the enclosed drawings:
- FIGS. 1A-E: show steps of a method for processing a CFET device according to an embodiment;
- FIGS. 2A-D: show steps of a method for processing a CFET device according to an embodiment;
- FIG. 3: shows a cross-sectional view of a CFET device according to an embodiment; and
- FIG. 4: shows electron microscope images of CFET devices according to an embodiment.

### DETAILED DESCRIPTION OF EMBODIMENTS

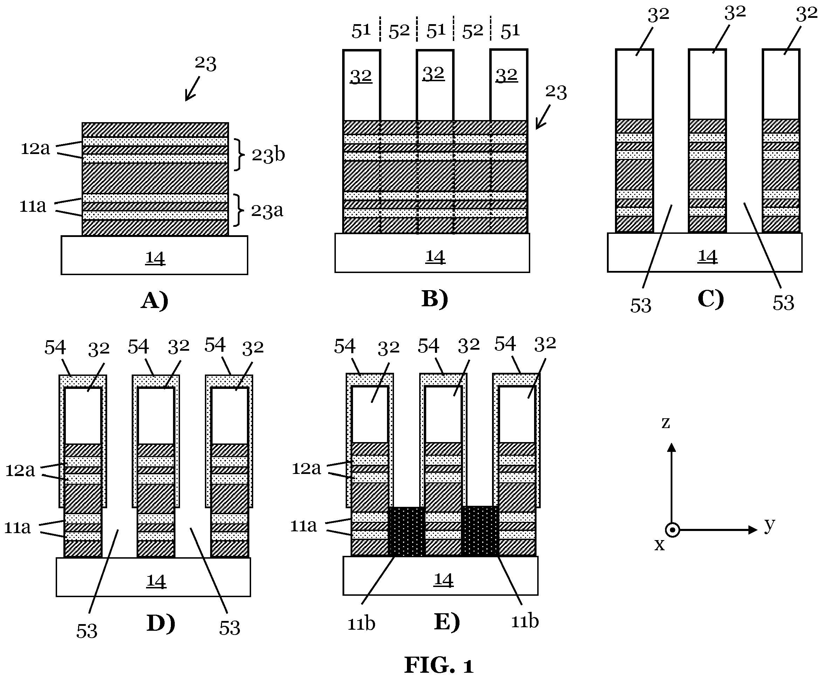

FIGS. 1A-E show steps of a method for processing a CFET device according to an embodiment. FIGS. 1A-E thereby show cross-section views through an y-z plane (as indicated by the Cartesian coordinate system), which is parallel to a channel direction (y-direction) of the CFET device.

In a first step, shown in FIG. 1A, the method comprises forming at least one fin structure 23 extending horizontally in one direction (here: the y-direction) on a substrate 14, wherein the at least one fin structure 23 comprises a first layer stack 23a and a second layer stack 23b above the first layer stack. The first layer stack 23a comprises at least a first channel layer 11a and the second layer stack 23b comprises at least a second channel layer 12a.

The first channel layer(s) 11a can form one or more channels of a first transistor structure of the CFET device and the second channel layer(s) 12a can form one or more channels of a second transistor structure of the CFET device. For instance, the first transistor structure is a bottom transistor structure and the second transistor structure is a top transistor structure of the CFET device. The bottom transistor structure can be a NMOS and the top transistor structure can be a PMOS, or vice versa.

The first and second layer stack 23a, 23b can be arranged directly on top of each other. Each layer stack 23a, 23b can comprise a plurality of alternating layers, comprising at least one channel layer (e.g., a Si layer) and at least one dielectric layer. For instance, each layer stack 23a, 23b can comprise alternating Si and SiGe layers. A top layer of the fin structure 23 can be a Si₃N₄ layer. A dielectric separation layer stack (e.g., middle dielectric isolation, MDI) can be formed between the first and second layer stack 23a, 23b. However, the dielectric separation layer stack can also a part of the first or the second layer stack 23a, 23b.

The fin structure 23 can be formed on the substrate 14 by active nanosheet patterning, e.g. by patterning of a nanosheet stack on the substrate 14. The nanosheet stack can comprise the layer stacks 23a, 23b and the dielectric separation layer stack. The substrate 14 can be a silicon substrate or a silicon-on-insulator (SOI) substrate.

In a second step, shown in FIG. 1B, the method comprises forming a set of gate structures 32 around the at least one fin structure 23, wherein the set of gate structures 32 are arranged perpendicular to the at least one fin structure 23 and at a determined distance to each other. Furthermore, the set of gate structures 32 cover the at least one fin structure 23 in channel regions 51 and exposes the at least one fin structure in fin cut regions 52 on opposite sides of the channel regions 51.

The gate structures 32 can extend along an x-direction (perpendicular to the channel direction) and wrap around the at least one fin structures 23. This can be referred to as gate all around design.

The gate structures 32 can be dummy gate structures that are replaced by replacement metal gates in a later step. The gate structures 32 can be formed on a gate dielectric layer (e.g., gate oxide) arranged around the fin structures 23.

In a further step, shown in FIG. 1C, the method comprises forming preliminary fin cuts by at least partially removing the at least one fin structure 23 in the fin cut regions 52, thereby generating a respective recess 53 between the gate structures 32, wherein end surfaces of the channel layers 11a, 12a of the first and the second layer stack 23a, 23b are exposed in the recess.

For instance, the fin structures 23 containing the channel layers 11a, 12a are at least partially removed in the fin cut regions 52. However, the channel layers 11a, 12a can stay intact in the channel regions 51 between the fin cut regions 52.

The fin structure 23 can be recessed in the fin cut regions 52 by means of a suitable wet or dry etching process. The position of the fin cut regions 52 can be defined by a lithographic mask, e.g. a fin cut mask.

After forming the fin cut regions, the SiGe layers of the first and/or second layer stack 23a, 23b can be removed and/or the middle dielectric isolation layer can be formed.

In a further step, shown in FIG. 1D, a cover layer 54 is formed. The cover layer 54 partially covers the side walls of the recess 53, and thereby covers the exposed end surfaces of the second channel layer(s) 12a but does not cover the exposed end surfaces of the first channel layer(s) 11a.

In particular, the cover layer 54 can be an inner spacer layer.

The cover layer can be a dielectric layer. For instance, the cover 54 layer is a silicon nitride (Si₃N₄, or short: SiN) layer, a silicon oxycarbide (SiOC) layer, a silicon oxynitride (SiON) layer or a silicon carbon nitride (SiCN) layer.

The cover layer 54 can be formed by a plasma enhanced atomic layer deposition (PEALD) process.

The cover layer 54 can be a non-conformal layer, e.g. a layer with a non-uniform layer thickness in the recess 53. The cover layer being non-conformal can have a number of different causes which are discussed in the following:

Firstly, the cover layer 54 can have an inherent low conformality as a consequence of the deposited process (e.g., PEALD) itself. For instance, the layer thickness of the cover layer 54 can gradually decrease from a top region of the recess 53 (the top region being a region that faces away from the substrate 14) towards a bottom region of the recess 53, which is directly above the substrate 14.

This gradual decrease of the layer thickness from top to bottom can be caused by and/or enhanced by the geometry of the recess 53. In particular, the high-aspect ratio of the gate structures 32 and/or the reduced space in between two gate structures 32 can lead to a reduced deposition (i.e., reduced deposition rate) of the cover layer 54 material in the bottom region of the recess 53 compared to the top region of the recess 53. For instance, there can be additional layers on the gate structure 32 side walls, e.g. a gate spacer, reducing the CPP (contacted poly pitch) at the ISP (inner spacer) module level. As a consequence, less film forming precursors or atoms may reach the bottom region during deposition due to the high aspect ratio (e.g., height and critical dimension space) of the gate structures 23 and/or the narrow recess 53 geometry.

The method may further comprise the step of forming an oxide (e.g., SiO₂) layer in the recess prior to forming the cover layer, wherein the cover layer is formed on the oxide layer. This may lead to a further reduction of the uniformity of the cover layer 54, e.g. when the PEALD SiN cover layer 54 is applied in combination with the oxide liner (ox+SiN) relying on the incubation of plasma SiN on oxide underlayer.

The oxide layer can be formed via a suitable deposition process, such as CVD or ALD. The oxide layer can also be formed due to intrinsic oxidation.

All these effects can be utilized to generate a non-conformal cover layer 54 with suitable target thicknesses at the top and at the bottom of the recess 53. In particular, the cover layer 54 can be sufficient to enable a cavity sealing of recessed SiGe layers of the first and second layer stack 23a, 23b.

After depositing the (non-uniform) cover layer 54, a part of the cover layer which was deposited in the bottom region of the recess 53 can be removed by a suitable etching step. For instance, the cover layer 54 in the bottom region of the recess can be removed by a wet etching step, e.g. with an HF solution. Subsequently, the CFET device can be cleaned with a soft ex-situ pre-epi cleaning step.

Thereby, the non-uniform layer thickness of the cover layer 54 can be utilized. For instance, the etching parameters (concentration of etchant, etching time) can be chosen such that the thinner cover layer 54 at the bottom of the recess 53 (covering the channel layers 11a of the first layer stack 23a) is fully removed while the thicker cover layer 54 at the top of the recess 53 (covering the channel layers 12a of the second layer stack 23a) stays intact.

As a consequence the end surfaces of the bottom channel layers are no longer covered by the cover layer 54 and can be contacted with a bottom source and/or drain (S/D) structures 11b in a next step shown in FIG. 1E.

The S/D structures 11b can be formed by an epitaxial growth process and are arranged to electrically contact the exposed end surfaces of the first channel layer(s) 11a, which are not covered by the cover layer 54.

For instance, the source and/or drain structures 11b are thereby only formed (e.g., grown) on surface regions of the recess 53 which are not covered by the cover layer 54. As a consequence, the source and/or drain structure 11b only contacts the exposed layers of the layer stack 23a (on the bottom of the recess) which are not covered by the cover layer. This can be due to the fact that the dielectric material of the cover layer 54 prevents an epitaxial growth of an S/D structure.

Prior to the S/D structures 11b formation, a pre-epi cleaning step can be carried out. Thereby, residues that may prevent a good epi growth on end surfaces of the Si channels can be removed.

Due to the non-conformal cover layer, no further layers or modules and, in particular, no cover spacer module and/or a spin-on-carbon are needed for engineering the bottom S/D structures 11b. Eliminating the need for a cover spacer module has the advantage of reducing the impact of downstream processing steps (deposition+etch+clean) needed for the cover spacer formation and removal. For instance, when applying a cover spacer module, additional plasma SiN or other dielectric layers would be deposited which are difficult to fully remove. Applying an excessive SiN removal step (wet or dry) to remove the cover spacer module can be detrimental for epi growth at the bottom of the recess 53.

The method for processing the CFET device may further comprise: forming a further (top) source and/or drain structure in the recess 53, wherein the further source and/or drain epi structure is arranged to electrically contact the second channel layer.

For instance, the (bottom) source and/or drain structure 11b is an n-type structure and the further (top) source and/or drain structure is a p-type structure or vice versa.

To form the further source and/or drain structure, the cover layer covering the end surfaces of the second channel layer 12a can be removed prior to the formation of the further source and/or drain structure.

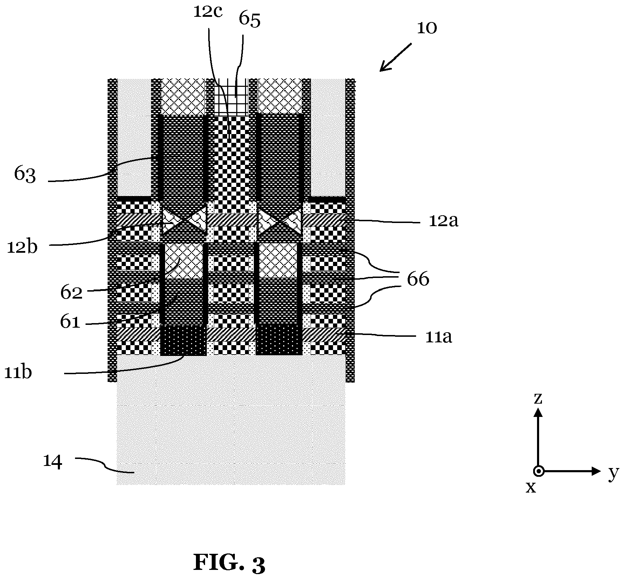

For instance, after formation of the (bottom) source and/or drain structure, a metal recess can be carried out and the cover layer 54 covering the second channel layer(s) 12a can be removed. This can be followed by a deposition of an Si₃N₄ liner and/or an SiO₂ layer in the recess. Subsequently, the Si₃N₄/SiO₂ layer(s) can be partially removed and a formation (e.g., metallization) of the further S/D structure can be carried out. A cross-section of a fully formed CFET with bottom and top S/D structures is shown in FIG. 3.

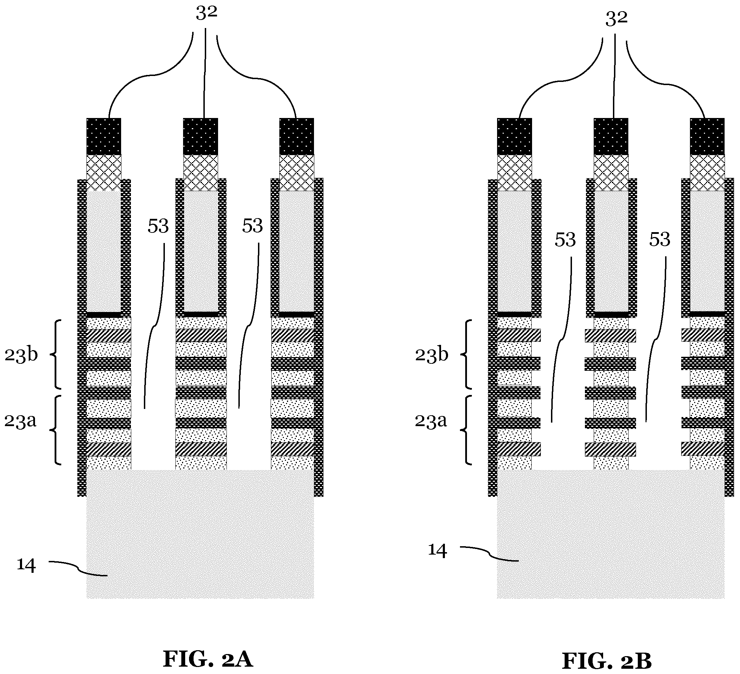

FIGS. 2A-D shows a process flow of the method for processing a CFET device according to an embodiment.

FIG. 2A shows a cross-sectional view of the fin structures 23 covered by the gate structures 32 after the fin cut step (as shown in FIG. 1C). The fin cut may also be referred to as S/D recess etch. The gate structures 32 can comprise a gate spacer to define this fin cut.

The (dummy) gate structures 32 can be formed from aSi (amorphous silicon). The gate structures 32 can comprise a silicon nitride (Si₃N₄) and silicon oxide (SiOₓ) layer on top.

In a next step, shown in FIG. 2B, a further cavity etch is carried out. Thereby, layers of the fin structure 23, e.g. SiGe layers, are at least partially removed.

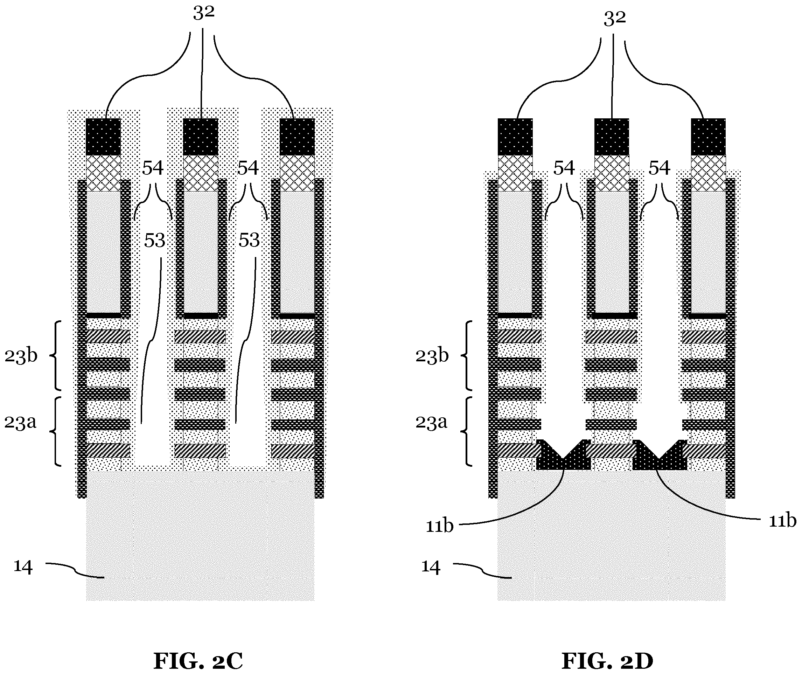

Subsequently, the cover layer 54 is deposited in the recesses 53 between the gate structures 32, as shown in FIG. 2C. Thereby, the cover layer 54 covering the bottom region of the recess 53, e.g. the bottom channel layer(s) 11a can have a lower layer thickness than the cover layer 54 covering the upper region of the recess, e.g. the top channel layer(s) 12a.

In an optional further step (not shown), the cover layer 54 can be further recessed (e.g., by wet etching), such that the layer 54 is fully removed in the bottom region and the end surfaces of the bottom channel layer 11a are exposed, while the top channel layer(s) 12a remain covered.

Then, as shown in FIG. 2D, the (bottom) source and/or drain structures 11b can be formed to be in electrical contact with the bottom channel layer(s) 11a. This formation can be carried out by an epitaxial growth process during which the S/D epi only grows in the regions of the recess 53 which are not covered by the cover layer 54.

FIG. 3 shows a CFET device 10 which was fabricated by the method as shown in any one of FIGS. 1A-E and/or FIG. 2.

As can be seen in FIG. 3, a bottom device S/D contact 61 can be arranged on top of the bottom S/D structure 11b, and a top device S/D contact 63 can be arranged on top of the top S/D structure 12. A contact isolation 62 can be arranged between the bottom device S/D contact 61 and the top S/D structure 12b.

The bottom and top S/D structures 11b, 12b can be formed from doped silicon, e.g. via an epitaxial growth process. For instance, the bottom S/D structure 11b can be formed from Si:B and the top S/D structure 12b can be formed from Si:P, or vice versa. In general, the bottom transistor structure can be an NMOS or a PMOS structure, depending on the requirements on the CFET device. Therefore, suitable materials for the bottom S/D structure 11b (e.g., SiGe:B for NMOS or Si:P for PMOS) can be chosen.

In the CFET device 10 shown in FIG. 3, the dummy gate structure 32 was replaced by a replacement metal gate 12c, which is electrically connected to a gate contact 65.

FIG. 3 further shows the middle dielectric isolation layers 66 which are arranged between layers of the fin structure 23, in particular between the bottom channel 11a and the top channel 12a.

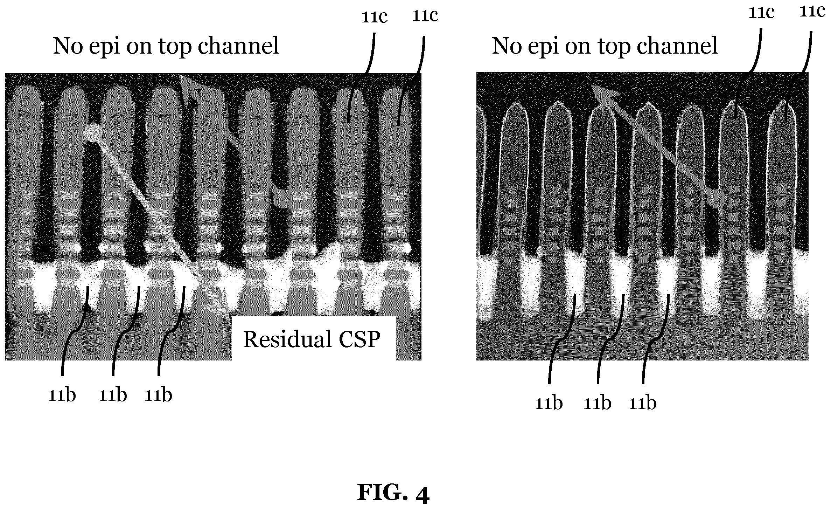

FIG. 4 shows electron microscope (EM) images of CFET devices according to an embodiment.

Both EM images show a cross section of a CFET device after formation of the bottom source and/or drain structure 11b. The CFET device shown in the left EM image was processed with a conventional technique using an additional cover spacer (CSP) module, and the CFET device in the right EM image was processed with the method as shown in FIGS. 1A-E and 2 utilizing a non-conformal cover layer 54 dielectric.

In both CFET devices, epi growth around the top channel 12a could be avoided during formation of the bottom S/D structure 11b. However, unwanted residual CSP material remains on the top region of the gate structures 32 of the CFET device in the left EM image. This unwanted CSP residuals are to be removed in further processing steps, which is possible source of damage to the device and increases fabrication efforts.

In contrast, no such residual remains on the CFET device shown in the right EM image and, thus, no extra processing steps are required.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A method for processing a complementary field effect transistor, CFET, device (10), comprising the steps of:
forming at least one fin structure (23) extending horizontally in one direction on a substrate (14), wherein the at least one fin structure (23) comprises a first layer stack (23a) and a second layer stack (23b) above the first layer stack, wherein the first layer stack (23a) comprises at least a first channel layer (11a) and the second layer stack (23b) comprises at least a second channel layer (12a);
forming a set of gate structures (32) around the at least one fin structure (23), wherein the set of gate structures (32) are arranged perpendicular to the at least one fin structure (23) and at a determined distance to each other, and wherein the set of gate structures (32) covers the at least one fin structure (23) in channel regions (51) and exposes the at least one fin structure (23) in fin cut regions (52) on opposite sides of the channel regions (51);
forming preliminary fin cuts by at least partially removing the at least one fin structure (23) in the fin cut regions (52), thereby generating a respective recess (53) between the gate structures (32), wherein end surfaces of the channel layers (11a, 12a) of the first and the second layer stack (23a, 23b) are exposed in the recess (53); and
forming a cover layer (54) which partially covers the side walls of the recess (53), wherein the cover layer (54) thereby covers the exposed end surfaces of the second channel layer(s) (12a) but does not cover the exposed end surfaces of the first channel layer(s) (11a).

2. The method of claim 1,
wherein the cover layer (54) is made of a dielectric material, such as SiN, SiOC, SiON or SiCN.

3. The method of claim 1 or 2,
wherein the cover layer (54) is formed by a plasma enhanced atomic layer deposition, PEALD, process.

4. The method of any one of the preceding claims,
wherein forming the cover layer (54) comprises:
depositing the cover layer (54) in the recess (53) with a non-uniform layer thickness.

5. The method of claim 4,
wherein the layer thickness of the cover layer (54) gradually decreases from a top region of the recess (53), which faces away from the substrate (14), towards a bottom region of the recess (53), which faces towards the substrate (14).

6. The method of claim 4 or 5,
wherein the cover layer (54) is deposited in the top region of the recess (53) with a higher deposition rate than in the bottom region of the recess (53).

7. The method of any one of claims 4 to 6,
wherein forming the cover layer (54) further comprises:
removing a portion of the cover layer (54) which was deposited in the bottom region of the recess (53) by an etching step.

8. The method of any one of the preceding claims, further comprising the step of:
forming an oxide layer in the recess (53) prior to forming the cover layer (54), wherein the cover layer (54) is formed on the oxide layer.

9. The method of any one of the preceding claims, further comprising the step of:
forming a source and/or drain structure (11b) in the recess (53), wherein the source and/or drain structure (11b) is arranged to electrically contact the exposed end surfaces of the first channel layer(s) (11a).

10. The method of claim 9,
wherein the source and/or drain structure (11b) is only formed on surface regions of the recess (53) which are not covered by the cover layer (54).

11. The method of claim 9 or 10,
wherein the source and/or drain structure (11b) is formed by an epitaxial growth process.

12. The method of any one of claims 9 to 11, further comprising the step of:
forming a further source and/or drain structure (12b) in the recess (53), wherein the further source and/or drain structure (12b) is arranged to electrically contact the second channel layer (12a).

13. The method of claim 12,
wherein the cover layer (54) covering the end surfaces of the second channel layer (12a) is removed prior to the formation of the further source and/or drain structure (12b).

14. A complementary field effect transistor, CFET, device (10) obtainable by the method according to any one of the preceding claims.
